(19) Europäisches Patentamt
European Patent Office
Office européen des brevets

(11) **EP 3 265 788 B1**

(12) **EUROPÄISCHE PATENTSCHRIFT**

(45) Veröffentlichungstag und Bekanntmachung des Hinweises auf die Patenterteilung:
**17.11.2021   Patentblatt 2021/46**

(21) Anmeldenummer: **16707736.1**

(22) Anmeldetag: **02.03.2016**

(51) Int Cl.:
*G01N 27/02* (2006.01)     *G01N 27/26* (2006.01)
*G01N 21/84* (2006.01)     *G01R 27/02* (2006.01)
*G01R 27/26* (2006.01)

(86) Internationale Anmeldenummer:
**PCT/EP2016/054398**

(87) Internationale Veröffentlichungsnummer:
**WO 2016/139233 (09.09.2016 Gazette 2016/36)**

(54) **ANORDNUNG ZUR ORTSAUFGELÖSTEN BESTIMMUNG DES SPEZIFISCHEN ELEKTRISCHEN WIDERSTANDS UND/ODER DER SPEZIFISCHEN ELEKTRISCHEN LEITFÄHIGKEIT VON PROBEN**

ARRANGEMENT FOR SPATIALLY RESOLVED DETERMINATION OF THE SPECIFIC ELECTRICAL RESISTANCE AND/OR THE SPECIFIC ELECTRICAL CONDUCTIVITY OF SAMPLES

AGENCEMENT POUR LA DÉTERMINATION À RÉSOLUTION SPATIALE DE LA RÉSISTANCE ÉLECTRIQUE SPÉCIFIQUE ET/OU DE LA CONDUCTIBILITÉ ÉLECTRIQUE SPÉCIFIQUE D'ÉCHANTILLONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.03.2015   DE 102015203807**
**30.04.2015   DE 102015000026**

(43) Veröffentlichungstag der Anmeldung:
**10.01.2018   Patentblatt 2018/02**

(73) Patentinhaber: **Fraunhofer-Gesellschaft zur Förderung der angewandten Forschung e.V.**
**80686 München (DE)**

(72) Erfinder:
- **WOLLMANN, Philipp**
  **01189 Dresden (DE)**
- **GRAEHLERT, Wulf**
  **01277 Dresden (DE)**
- **WEISSENBORN, Eric**
  **01187 Dresden (DE)**

(74) Vertreter: **Pfenning, Meinig & Partner mbB Patent- und Rechtsanwälte**
**An der Frauenkirche 20**
**01067 Dresden (DE)**

(56) Entgegenhaltungen:
**EP-A1- 1 257 806      DE-A1- 4 412 238**
**JP-A- 2007 298 480    JP-A- 2011 179 971**
**US-A- 5 107 119       US-A1- 2002 153 874**
**US-A1- 2010 006 785   US-A1- 2010 179 792**
**US-A1- 2014 021 967   US-B1- 8 927 933**

- **KADI M ET AL: "Reflectance modeling of electrochemically P-type porosified silicon by Drude-Lorentz m", APPLIED SURFACE SCIENCE, ELSEVIER, AMSTERDAM, NL, vol. 312, 13 June 2014 (2014-06-13), pages 34-38, XP029038996, ISSN: 0169-4332, DOI: 10.1016/J.APSUSC.2014.06.046**
- **KADI MOHAMED ET AL: "Analysis of optical and related properties of tin oxide thin films determined by Drude-Lorentz model", SURFACE AND COATINGS TECHNOLOGY, vol. 211, 18 October 2011 (2011-10-18), pages 45-49, XP028957309, ISSN: 0257-8972, DOI: 10.1016/J.SURFCOAT.2011.10.027**

## Beschreibung

Die Erfindung betrifft eine Anordnung zur ortsaufgelösten Bestimmung des spezifischen elektrischen Widerstands und/oder der spezifischen elektrischen Leitfähigkeit von Proben, insbesondere von auf einer Oberfläche vorhandenen elektrisch leitenden Beschichtungen.

Bisher werden der spezifische elektrische Widerstand bzw. die spezifische elektrische Leitfähigkeit ortsaufgelöst mittels Mapping der so genannten Vierpunktmessung oder über Wirbelstrommessungen (Eddy-Current) bestimmt. Dabei muss für die Vierpunktmessung aber eine unmittelbare Kontaktierung an einer Probe erfolgen, was einmal einen erhöhten Aufwand darstellt und zum anderen eine Schädigung oder Beeinflussung der Oberfläche bewirkt. Durch die erforderliche Kontaktierung ist auch eine entsprechende Zugänglichkeit für elektrische Verbindungen zu den Messpunkten erforderlich. Wirbelstrommessungen können zur Untersuchung höherer elektrischer Widerstände und Proben geringerer elektrischer Leitfähigkeit nicht genutzt werden. Außerdem ist es für die erwähnten Methoden bislang nachteilig, dass bei größeren Proben die Bestimmung mehrfach an verschiedenen Positionen durchgeführt werden muss und trotzdem eine begrenzte örtliche Auflösung in Kauf genommen werden muss.

So beschreibt die Druckschrift DE 44 12 238 A1 eine optische Meßanordnung zur Bestimmung charakteristischer Halbleiterparameter. Die Druckschrift JP 2011179971 A beinhaltet ein System für die zerstörungsfreie Messung an dünnen Filmen. In dem Dokument EP 1 257 806 B1 ist ebenfalls ein Verfahren und eine Vorrichtung zur Vermessung dünner Filme vorgeschlagen. Das Dokument US 5 107 119 bezieht sich insbesondere auf Messungen an supraleitenden Filmen.

Es ist daher Aufgabe der Erfindung, Möglichkeiten für die berührungslose Bestimmung des spezifischen elektrischen Widerstandes und/oder der spezifischen elektrischen Leitfähigkeit simultan ortsaufgelöst aufzuzeigen.

Erfindungsgemäß wird diese Aufgabe mit einer Anordnung, die die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Die Erfindung basiert auf einer örtlich auflösenden optisch-spektroskopischen Analyse einer Probe. Die simultan ortsaufgelöst erfassten Spektren werden dabei mittels eines Drude-Modells als physikalisches Modell oder Funktion zur Beschreibung des wellenlängenabhängigen Verlaufes des komplexen Brechungsindex (der wellenlängenabhängige Verlauf des realen Brechungsindex und des Absorptionskoeffizienten bzw. der dielektrischen Funktion) von elektrisch leitfähigen Materialien/Werkstoffen und unter Verwendung vorteilhafter Algorithmen zur Beschreibung der Strahlausbreitung elektromagnetischer Strahlung in Schichtsystemen mit Fresnelschen Formeln dahingegen ausgewertet, dass die Drude-Parameter des physikalischen Modells (z.B. $\rho$ - spezifischer Widerstand, $\tau$ - mittlere Stoßzeit, $\varepsilon_\infty$ - Hochfrequenz-dielektrische Konstante, $\omega_P$ - Plasmafrequenz, $\mu$ - Ladungsträgermobilität) bestimmt werden können.

Anhand dieser Parameter kann direkt die Ladungsträgerdichte (N) in Festkörpern bestimmt werden. Unter Berücksichtigung der Schichtdicke kann ebenso der Flächenwiderstand ortsaufgelöst bestimmt werden.

Dabei sind mehrere Detektoren, die zur ortsaufgelösten spektralen Analyse elektromagnetischer Strahlung innerhalb eines Wellenlängenintervalls ausgebildet sind, in einer Reihen oder einer Reihen- und Spaltenanordnung angeordnet. Die Detektoren sind mit einer elektronischen Auswerteeinheit verbunden und so angeordnet, dass von einer breitbandigen Strahlungsquelle emittierte elektromagnetische Strahlung entweder nach einer Reflexion an der Oberfläche der Probe, einer auf der Probe ausgebildeten Schicht oder an der Oberfläche einer Schicht innerhalb der Probe und/oder nach dem Durchstrahlen einer für die elektromagnetische Strahlung transparenten Probe auf die Detektoren auftrifft. Die Bestrahlung der Probenoberfläche erfolgt dabei so, dass auf einer Fläche, von der die elektromagnetische Strahlung reflektiert oder durch die Fläche transmittiert wird, eine homogene Intensität der elektromagnetischen Strahlung eingehalten ist.

Die elektronische Auswerteeinheit ist so ausgebildet, dass die orts- und wellenlängenaufgelöst erfassten Messsignale der Detektoren innerhalb eines Wellenlängenintervalls mit jeweils einem Verlauf verglichen werden, der sich anhand der physikalischen Beschreibung der wellenlängenabhängigen Strahlausbreitung elektromagnetischer Strahlung in Schichtsystemen unter Verwendung eines das Schichtsystem beschreibenden optischen Modells, insbesondere unter Verwendung des Drudemodells zur parametrisierten Beschreibung des wellenlängenabhängigen Verlaufes des komplexen Brechungsindex, ergibt. Durch eine vorteilhafte Auswahl der Drudeparameter bzw. deren vorteilhafte Änderung können die orts- und wellenlängenaufgelöst erfassten Messsignale der Detektoren mit den jeweiligen modellbasierten Verläufen zu einer hinreichenden Deckung gebracht werden, womit der spezifische elektrische Flächenwiderstands und/oder die spezifische elektrischen Leitfähigkeit der jeweiligen Probe oder mindestens einer auf oder an der Probe ausgebildeten Schicht für die erfassten Messpositionen und somit deren ortsaufgelöste Verteilung bestimmt werden kann.

Bei der Messung werden mit den Detektoren ortsaufgelöst an mehreren Positionen die erfassten Intensitäten für eine Vielzahl von Wellenlängen bestimmt.

Man erhält für jede betrachtete Position ein wellenlängenaufgelöstes Spektrum von detektierten Intensitätsmesswerten. Der Kurvenverlauf der detektierten Intensitätsmesswerte wird mit einem Kurvenverlauf verglichen, der einmalig vorab für das interessierende Probensystem ermittelt wurde (beispielsweise unter Verwendung von Ellipsometermessungen), wobei die dabei verwendeten Drudeparameter, die Startwerte für eine iterative Bestimmung der Drudeparameter darstellen. Die Drudeparameter können ebenso geschätzt werden.

Das Drude-Modell kann gemäß folgender Gleichungen verwendet werden:

$$\varepsilon_{Drude} = \varepsilon_{\infty} - (\hbar^2 / (\varepsilon_0 * \rho * (\tau * E^2 + (i * \hbar * E)))) \qquad (1)$$

$$n = (0{,}5 * ((\varepsilon_{Drude,\,real}^2 + \varepsilon_{Drude,\,imaginär}^2)^{1/2} + \varepsilon_{Drude,\,real}))^{1/2} \qquad (2)$$

$$k = (0{,}5 * ((\varepsilon_{Drude,\,real}^2 + \varepsilon_{Drude,\,imaginär}^2)^{1/2} - \varepsilon_{Drude,\,real}))^{1/2} \qquad (3)$$

Auf Grundlage der Gleichung (1) werden anhand von drei Parametern (p - spezifischer Widerstand, $\tau$ - mittlere Stoßzeit, $\varepsilon_{\infty}$ - Hochfrequenz-dielektrische Konstante) die realen Brechungsindizes n und die Absorptionskoeffizienten $k$ für jede Energie $E$ für das jeweilige elektrisch leitfähige Material/Werkstoff berechnet. Die und für jede zu beachtende Position der bestrahlten und detektierten Fläche kann so ein entsprechender Kurvenverlauf, bei dem nach Gleichung (2) die realen optischen Brechungsindizes $n$ oder nach Gleichung (3) die Absorptionskoeffizienten $k$ in Bezug zu den an den jeweils gleichen Positionen erfassten Intensitätsmesswerten aufgetragen sind, erhalten werden.

Tritt eine zu große Abweichung des mit den drei Parametern berechneten Kurvenverlaufs zu dem Kurvenverlauf an den erfassten Messpositionen auf, kann iterativ eine Anpassung durch Veränderung von Parametern der Drude-Gleichung (1) erfolgen, mit der der Kurvenverlauf berechnet wird auf, bis die beiden miteinander zu vergleichenden Kurvenverläufe ausreichend übereinstimmen.

Mit einem optischen Modell, können der reale optische Brechungsindex n und der Absorptionskoeffizient k des Werkstoffs der jeweiligen Probe und/oder einer auf einer Oberfläche einer Probe vorhandenen Beschichtung berücksichtigt oder berechnet werden. Bei Beschichtungen ist die jeweilige Schichtdicke $d$ ebenfalls zu berücksichtigen. Dies kann durch die Bestimmung von Fresnelkoeffizienten und einen Transfermatrixansatz, was nachfolgend noch näher beschrieben wird, erreicht werden. Die weiteren Parameter der Drude-Gleichung (1) sind die Stoßzeit $\tau$, die Hochfrequenz-dielektrische Konstante $\varepsilon_{\infty}$, und der spezifische elektrische Widerstand $\rho$. Diese können bei der Bestimmung des spezifischen elektrischen Widerstands oder der spezifischen Leitfähigkeit berücksichtigt werden. Die Lösung der Gleichung (1) erfolgt durch numerische Optimierungsalgorithmen, besonders bevorzugt ist dabei die Methode der kleinsten Quadrate und davon abgeleitete Methoden.

Das Verhalten der elektromagnetischen Strahlung an den Grenzflächen einer Probe kann unter Berücksichtigung der komplexen Brechungsindizes der an den Grenzflächen beteiligten Materialien/Werkstoffen, des Einfallswinkels und der Polarisation der elektromagnetischen Strahlung und durch Berechnung der Fresnelkoeffizienten berücksichtigt werden.

Es sollte dabei beachtet werden, ob die mit Detektoren erfassten Intensitätsmesswerte von nach einer Reflexion R auf Detektoren auftreffender elektromagnetischer Strahlung oder nach Durchstrahlung einer Probe also Transmission $T$ erfasst worden sind. Aus den Fresnelkoeffizienten der einzelnen Grenzflächen aus denen die jeweilige Probe (z.B. Substrat/Schicht oder Schicht/Schicht, oder Schicht/Luft) gebildet ist, kann durch einen Transfermatrixansatz oder eine andere mathematische Transformation die Schichtdicke $d$, die Gesamtintensität der elektromagnetischen Strahlung für die erfassten Messpositionen der Probe wellenlängenabhängig und unter Berücksichtigung der Messbedingungen, wie Polarisation der Strahlung und/oder des Einfallswinkels, berechnet werden. Dies betrifft insbesondere die Gesamtreflexion $R$ und/oder die Gesamttransmission $T$.

Bei einer nicht hinreichenden Übereinstimmung der Verläufe von detektierten und berechneten Intensitätsmesswerten erfolgt eine Anpassung der angenommenen Parameter der Drude-Gleichung (1) und ggf. der Schichtdicke der durch die Drudefunktion beschriebenen Schicht an einem Substrat oder des Substrats an sich. Die Berechnung und der Vergleich mit dem Verlauf der detektierten Intensitätswerte werden so oft wiederholt, bis eine ausreichende Übereinstimmung beider Verläufe erreicht worden ist. Dies kann man als Fit (Regression, Ausgleichsrechnung) bezeichnen. Die Ausgleichsrechnung kann insbesondere durch die Methode der kleinsten Quadrate und davon abgeleiteten numerischen Optimierungsalgorithmen (z.B. Levenberg-Marquardt-Algorithmus) vorgenommen werden.

Bei der Erfassung der Intensitätsmesswerte sollten in einer Reihe mindestens 30, bevorzugt mindestens 100 Detektoren angeordnet sein.

Gemäß einem nicht beanspruchten Beispiel sollte die Bestrahlung der Fläche mit mindestens einem Winkel im Bereich 0° bis < 90° in Bezug zur Normalen der Oberfläche der Probe erfolgen. Bei einer Durchstrahlung (Transmission) einer für die elektromagnetische Strahlung transparenten Probe, sollte der Winkel bevorzugt von zumindest nahezu 0° zur Probennormalen eingehalten sein, also die Strahlung möglichst senkrecht auf die Oberfläche der Probe gerichtet werden. Die Bestrahlung und Detektion kann auch bei mehreren Einfallswinkeln der elektromagnetischen Strahlung simultan oder sequentiell durchgeführt werden. Wie bereits zum Ausdruck gebracht können dabei Einfallswinkel gemäß einem nicht beanspruchten Beispiel im Bereich 0° bis maximal 89° gewählt werden. Gemäß der Erfindung werden Einfallswinkel im Bereich 60° bis 80° verwendet, wenn reflektierte Strahlung detektiert werden soll, unabhängig davon, ob ein konstanter Einfallswinkel oder verschiedene Einfallswinkel eingesetzt werden sollen.

Die Bestrahlung und/oder die Detektion kann/können auch mit polarisierter elektromagnetischer Strahlung erfolgen. In diesem Fall kann die Ausrichtung der Polarisationsebene gewechselt und die elektromagnetische Strahlung mit unterschiedlicher Polarisation emittiert und/oder entsprechend detektiert werden.

Insbesondere bei großflächigen Proben können die Detektoren und die Probe entlang mindestens einer Achse relativ und dabei bevorzugt in einem konstanten Abstand zueinander bewegt werden. So kann bei statisch fixierten Detektoren und Strahlungsquelle eine Probe in einer Achse bewegt werden. Dies kann mit einem entsprechend beweglichen Tisch, auf dem eine Probe angeordnet ist, in einer x- und ggf. auch in einer y-Richtung bewegt werden. Es ist aber auch die Abwicklung von Rolle zu Rolle möglich, wenn die Probe aus einem flexibel verformbaren Werkstoff, beispielsweise in Form einer Folie vorliegt.

An der Strahlungsquelle können die elektromagnetische Strahlung formende Elemente vorhanden sein, die eine vorteilhafte Abbildung bzgl. Probengröße und laterale Auflösung und/oder die vorteilhafte homogene Beleuchtung der Probenoberfläche gewährleisten. In einer Ausführung kann dieses Element ein Mikroskop sein. Es kann aber auch ein Hohlkörper mit vorteilhaft angeordneter Strahlungsquelle (oder mehrerer) sein, der eine elektromagnetische Strahlung diffus und somit homogen auf die zu bestrahlende Fläche richten kann. Der Hohlkörper kann eine Kugel oder Zylinder sein. Es sollte eine gleichzeitig zu detektierende Fläche homogen bestrahlt werden können. Bei einer Strahlungsquelle mit strahlformenden optischen Elementen sollten bei der Auswahl der jeweils eingesetzten optischen Elemente, die zur Strahlformung dienen, der genutzte Wellenlängenbereich berücksichtigt werden.

Bevorzugt kann im Strahlengang der elektromagnetischen Strahlung eine den Einfall von gestreuter elektromagnetischer Strahlung vermeidende Blende vor den Detektoren angeordnet sein.

Von der Strahlungsquelle kann elektromagnetische Strahlung emittiert werden, deren Wellenlängen bei der UV-Strahlung beginnen und bei der IR-Strahlung enden. Besonders bevorzugt ist Strahlung aus dem Spektralbereich von 250 nm bis 25000 nm. Es sollten in einem genutzten Wellenlängenbereich für die Bestrahlung möglichst alle Wellenlängen innerhalb des jeweiligen Intervalls genutzt werden können. Die Grenzen sollten allein durch den Empfindlichkeitsbereich der eingesetzten Detektoren und den optischen Eigenschaften der Strahlführungskomponenten vorgegeben sein.

Es kann dort auch mindestens ein Element, mit dem eine gezielte Wahl der Polarisation der elektromagnetischen Strahlung erreichbar ist, vorhanden oder darin integriert sein.

Eine Probe kann auch ein Mehrschichtaufbau, mehrerer aus unterschiedlichen Materialien oder Werkstoffen gebildeten Schichten, sein. Dies kann beispielsweise ein Substrat sein, auf dem für die eingesetzte elektromagnetische Strahlung zumindest teilweise transparente Schichten ausgebildet sind. Dabei kann auch das Substrat entsprechend transparent sein. Die Transparenz kann einen Teil des Wellenlängenspektrums der emittierten elektromagnetischen Strahlung und/oder einen nichtabsorbierten Teil des gesamten Wellenlängenspektrums der Strahlung betreffen.

Die eingesetzten Detektoren und die elektronische Auswerteeinheit sowie auch die Strahlungsquelle bilden ein so genanntes Hyper-Spektral-Image-System.

Die gleichzeitig ortsaufgelöst detektierten Spektren (an jeder erfassten Position) können bzgl. des interessierenden Material- oder Werkstoffparameters oder seiner Eigenschaft folgendermaßen ausgewertet werden.

Es kann eine Kombination unterschiedlicher Messbedingungen erfolgen. Dabei können Transmission/Reflexionsmessung, Kombination unterschiedlicher Einfallswinkel, die Verwendung und Kombination unterschiedlicher Polarisationsebenen der elektromagnetischen Strahlung in unterschiedlichster Form miteinander kombiniert werden.

Es besteht auch die Möglichkeit, mehrere Reihen- oder Reihen- und Spaltenanordnungen von Detektoren, die dann beispielsweise in Bewegungsrichtung nacheinander angeordnet sein können, einzusetzen. Diese Anordnungen von Detektoren können jeweils bei unterschiedlichen Messbedingungen detektieren.

Mit Anordnungen von Detektoren, deren Zeile/Reihe durch Verwendung von unterschiedlichen optischen Anordnungen (unterschiedliche optische Elemente) ausgebildet ist oder die modifiziert werden können, kann bei unterschiedlichen Messbedingungen detektiert werden.

Gegenüber den bekannten Messverfahren kann eine wesentlich höhere Ortsauflösung bis hin zu einer nahezu vollständigen Berücksichtigung der gesamten Oberfläche einer Probe oder Beschichtung erreicht werden. Es kann eine vollständige bzw. nahezu vollständige Qualitätskontrolle und dies auch noch unmittelbar bei einem Herstellungs- oder Bearbeitungsprozess erreicht werden.

Die Erfindung kann bei verschiedenen technischen Gebieten, beispielsweise in der Halbleiterindustrie, der Photovoltaikherstellung, die Herstellung von aktiv nutzbaren Paneelen, wie Touchscreens, Flachbildschirmen, in der Herstellung von Antielektrostatika, von Elektrodenmaterialien, von Flächenheizungen oder auch Lichtquellen (OLED's) eingesetzt werden. So kann beispielsweise der spezifische elektrische Widerstand von Schichten aus einem optisch transparenten Oxid (TCO), wie insbesondere Indium-Zinn-Oxid (ITO) ortsaufgelöst bestimmt werden.

Nachfolgend soll die Erfindung beispielhaft näher erläutert werden.

Dabei zeigen:

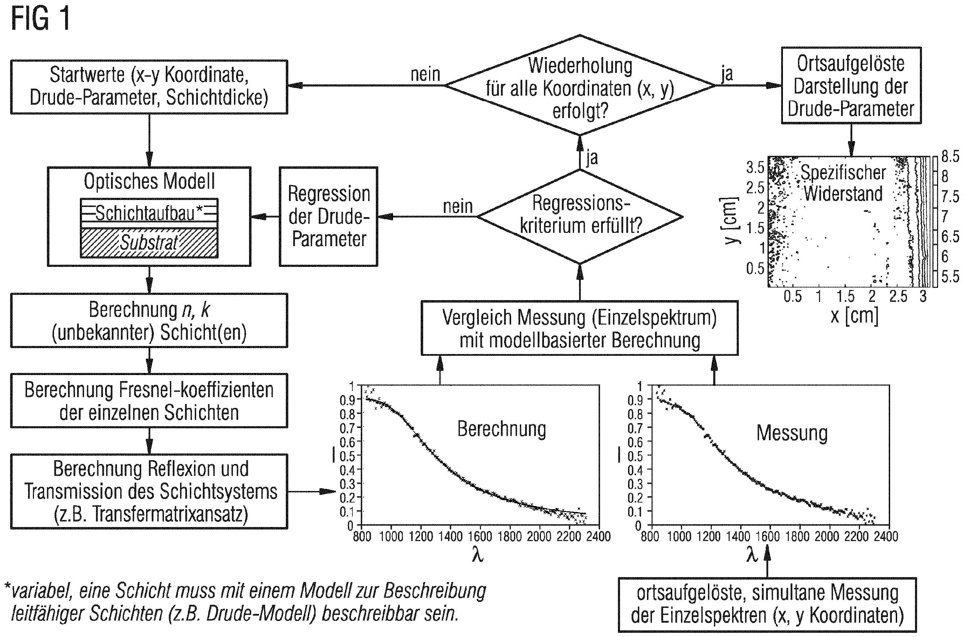

Figur 1    in schematischer Form, wie der spezifische elektrische Widerstand in erfindungsgemäßer Form bestimmbar ist und

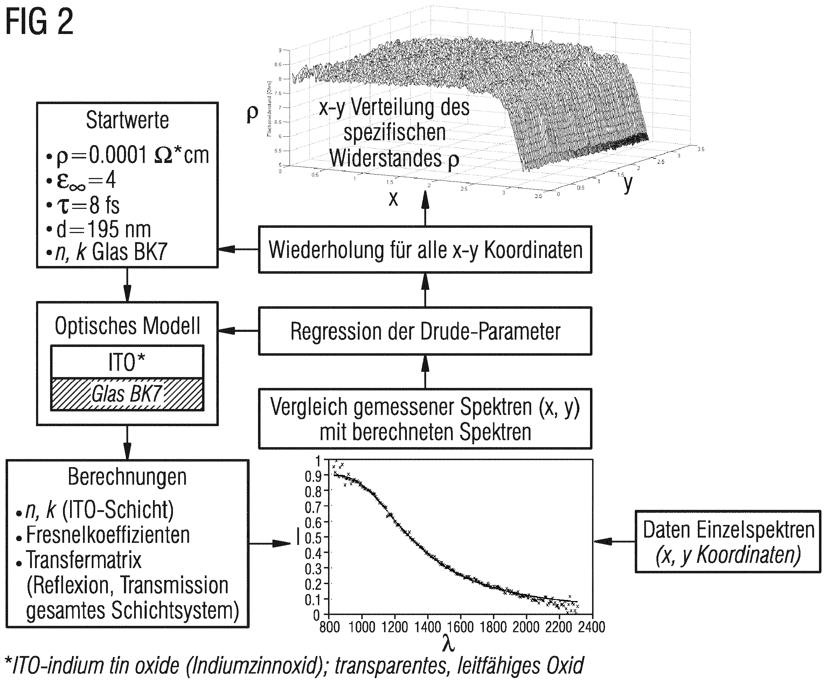

Figur 2    in schematischer Form ein mögliches Vorgehen zur Bestimmung des spezifischen elektrischen Widerstands einer Schicht aus ITO auf einem Substrat aus einem Glas BK7.

## Zusammenfassung

Die Erfindung betrifft eine Anordnung zur ortsaufgelösten Bestimmung des spezifischen elektrischen Widerstandes und/oder der spezifischen elektrischen Leitfähigkeit einer Probe und/oder mindestens einer auf einer Oberfläche einer Probe ausgebildeten Schicht an unterschiedlichen Positionen. Dabei sind mehrere Detektoren, die zur ortsaufgelösten spektralen Analyse elektromagnetischer Strahlung innerhalb eines Wellenlängenintervalls ausgebildet sind, in einer Reihen oder einer Reihen- und Spaltenanordnung angeordnet. Die Detektoren sind mit einer elektronischen Auswerteeinheit verbunden und so angeordnet, dass von einer breitbandigen Strahlungsquelle emittierte elektromagnetische Strahlung entweder nach einer Reflexion an der Oberfläche der Probe, einer auf der Probe ausgebildeten Schicht oder an der Oberfläche einer Schicht innerhalb der Probe und/oder nach dem Durchstrahlen einer für die elektromagnetische Strahlung transparenten Probe auf die Detektoren auftrifft. Die Bestrahlung erfolgt so, dass auf einer Fläche, von der die elektromagnetische Strahlung reflektiert oder durch die Fläche transmittiert wird, eine homogene Intensität der elektromagnetischen Strahlung eingehalten ist. Die elektronische Auswerteeinheit so ausgebildet ist, dass die orts- und wellenlängenaufgelöst erfassten Messsignale der Detektoren innerhalb eines Wellenlängenintervalls für jede erfasste Position, mit einer wellenlängenaufgelösten Funktion, die durch Berechnung der Ausbreitung elektromagnetischer Strahlung in Mehrschichtsystemen, insbesondere unter Berücksichtigung der der Fresnelschen Formeln, unter Verwendung eines optischen Modells zur physikalischen Beschreibung der untersuchten Probe, unter Berücksichtigung der wellenlängenabhängigen Verläufe der linearen optischen Brechungsindizes n und Absorptionskoeffizienten k aller, die Probe bildenden Materialien und/oder Werkstoffe, wobei die des interessierenden Materials oder Werkstoffs durch eine physikalische Funktion (Beschreibung) des komplexen Brechungsindex des leitfähigen Materials oder Werkstoffs, verglichen werden, und durch eine vorteilhafte Änderung von der Parametern der physikalischen Funktion iterativ zu einer hinreichenden Deckung mit einem Kalibrierkurvenverlauf gebracht werden, um den spezifischen elektrischen Widerstand und/oder die spezifische elektrische Leitfähigkeit an verschiedenen Positionen ortsaufgelöst bestimmen zu können.

## Patentansprüche

1.  Anordnung zur ortsaufgelösten Bestimmung des spezifischen elektrischen Widerstandes und/oder der spezifischen elektrischen Leitfähigkeit einer Probe und/oder mindestens einer auf einer Oberfläche einer Probe ausgebildeten Schicht an unterschiedlichen Positionen, bei der mehrere Detektoren, die zur ortsaufgelösten spektralen Analyse elektromagnetischer Strahlung innerhalb eines Wellenlängenintervalls ausgebildet sind, in einer Reihen oder einer Reihen- und Spaltenanordnung angeordnet und

    die Detektoren mit einer elektronischen Auswerteeinheit verbunden und so angeordnet sind, dass von einer breitbandigen Strahlungsquelle emittierte elektromagnetische Strahlung nach einer Reflexion an der Oberfläche der Probe und/oder einer auf der Probe ausgebildeten Schicht oder an der Oberfläche einer Schicht innerhalb der Probe auf die Detektoren auftrifft, wobei
    die Bestrahlung so erfolgt, dass auf einer Fläche, von der die elektromagnetische Strahlung reflektiert oder durch die Fläche transmittiert wird, eine homogene Intensität der elektromagnetischen Strahlung eingehalten ist und
    die elektronische Auswerteeinheit so ausgebildet ist,
    dass die orts- und wellenlängenaufgelöst erfassten Messsignale der Detektoren innerhalb eines Wellenlängenintervalls für jede erfasste Position,
    mit einer wellenlängenaufgelösten Funktion, die durch Berechnung der Ausbreitung elektromagnetischer Strahlung in Mehrschichtsystemen unter Berücksichtigung der Fresnelschen Formeln,
    unter Verwendung eines optischen Modells zur physikalischen Beschreibung der untersuchten Probe, unter Berücksichtigung der wellenlängenabhängigen Verläufe der linearen optischen Brechungsindizes $n$ und Absorptionskoeffizienten $k$ aller, die Probe bildenden Materialien und/oder Werkstoffe, wobei die des interessierenden Materials oder Werkstoffs durch eine physikalische Funktion des komplexen Brechungsindex des leitfähigen Materials oder Werkstoffs durch das Drude-Modell approximierbar ist,

verglichen werden, und

durch eine vorteilhafte Änderung von den Drude-Parametern der physikalischen Funktion zu einer hinreichenden Deckung mit einem Kalibrierkurvenverlauf gebracht werden,

um den spezifischen elektrischen Widerstand und/oder die spezifische elektrische Leitfähigkeit an verschiedenen Positionen ortsaufgelöst bestimmt werden, wobei

die Detektoren, die elektronische Auswerteeinheit und die Strahlungsquelle ein Hyper-Spektral-Image-System bilden, wobei der Einfallswinkel der elektromagnetischen Strahlung im Bereich 60° bis 80° in Bezug zur Normalen der Oberfläche der Probe veränderbar oder einstellbar ist, wobei die Detektion und Auswertung bei mehreren unterschiedlichen Einfallswinkeln durchführbar ist.

2. Anordnung nach Anspruch 1, **dadurch gekennzeichnet, dass** die elektronische Auswerteeinheit so ausgebildet ist, dass eine Anpassung des berechneten Kurvenverlaufs an den Kurvenverlauf einer Kalibrierung iterativ durch Variation von Parametern der Drude-Gleichung erreichbar ist.

3. Anordnung nach einem der vorhergehenden Ansprüche, **dadurch gekennzeichnet, dass** die Detektion und Auswertung unter Verwendung eines Polarisators mit definierter bekannter Polarisationsebene in Bezug zur Einfallsebene durchführbar ist.

4. Anordnung nach einem der vorhergehenden Ansprüche, **dadurch gekennzeichnet, dass** die laterale Verteilung der Schichtdicke(n),

die optische(n) Brechungskonstante(n), oder deren wellenlängenabhängiger Verlauf,
die Absorptionskonstante(n), oder deren wellenlängenabhängiger Verlauf,
der Oberflächen- bzw. Interfacegüte der Probe oder mindestens einer auf der Probe ausgebildeten Schicht,
die Ladungsträgerkonzentration und/oder die Anzahl und/oder Größe und/oder Form von Defekten und/oder Partikeln in der Probe oder mindestens einer Schicht bestimmbar ist.

5. Anordnung nach einem der vorhergehenden Ansprüche, **dadurch gekennzeichnet, dass** die Detektoren und die Probe entlang mindestens einer Achse relativ und dabei bevorzugt in einem konstanten Abstand zueinander bewegbar sind.

6. Anordnung nach einem der vorhergehenden Ansprüche, **dadurch gekennzeichnet, dass** die Strahlungsquelle die elektromagnetische Strahlung formende optische Elemente aufweist oder eine elektromagnetische Strahlung diffus auf die Fläche emittierende Strahlungsquelle, die insbesondere innerhalb eines Hohlkörpers angeordnet ist und besonders bevorzugt im Strahlengang der elektromagnetischen Strahlung eine, den Einfall von gestreuter elektromagnetischer Strahlung vermeidende Blende vor den Detektoren angeordnet ist.

7. Anordnung nach einem der vorhergehenden Ansprüche, **dadurch gekennzeichnet, dass** die Probe ein Mehrschichtaufbau, mehrerer aus unterschiedlichen Materialien oder Werkstoffen gebildeten Schichten, ist.

**Claims**

1. An arrangement for the spatially resolved determination of the specific electrical resistance and/or of the specific electrical conductivity of a sample and/or of at least one layer formed on a surface of a sample at different positions, in which a plurality of detectors that are configured for a spatially resoled spectral analysis of electromagnetic radiation within a wavelength interval are arranged in a row arrangement or in a row and column arrangement; and

the detectors are connected to an electronic evaluation unit and are arranged such that electromagnetic radiation emitted by a broadband radiation source impacts the detectors after reflection at the surface of the sample and/or at a layer formed on the sample or at the surface of a layer within the sample; wherein
the irradiation takes place such that a homogeneous intensity of the electromagnetic radiation is observed on a surface from which the electromagnetic radiation is reflected or through which it is transmitted; and
the electronic evaluation unit is configured such that
the measurement signals of the detectors detected with spatial resolution and wavelength resolution within a wavelength interval for each detected position;

are compared with a wavelength-resolved function that by calculation of the propagation of electromagnetic radiation in multilayer systems, while taking account of the Fresnel formulas,

using an optical model for a physical description of the examined sample while taking account of the wavelength-dependent progressions of the linear optical refractive indices n and the absorption coefficients k of all the materials and/or substances forming the sample, wherein that of the material or substance of interest can be approximated by a physical function of the complex refractive index of the conductive material or substance by the Drude model,

and

are brought to a sufficient overlap with a calibration curve progression by an advantageous change of the Drude parameters of the physical function,

to determine the specific electrical resistance and/or the specific electrical conductivity with spatial resolution at different positions, wherein

the detectors, the electronic evaluation unit, and the radiation source form a hyperspectral image system, wherein the angle of incidence of the electromagnetic radiation can be changed or set in the range of 60° to 80° with respect to the normal of the surface of the sample, wherein the detection and evaluation can be carried out at various angles of incidence.

2. An arrangement in accordance with claim 1, **characterized in that** the electronic evaluation unit is configured such that an adaptation of the calculated curve progression to the curve progression of a calibration can be achieved iteratively by varying parameters of the Drude equation.

3. An arrangement in accordance with one of the preceding claims, **characterized in that** the detection and evaluation can be carried out while using a polarizer having a defined, known polarization plane in relation to the plane of incidence.

4. An arrangement in accordance with one of the preceding claims, **characterized in that** the lateral distribution of the layer thickness(es),

the optical refractive constant(s) or its/their wavelength-dependent progression,
the absorption constant(s) or its/their wavelength-dependent progression
of the surface quality or interface quality (roughness) of the sample or of at least one layer formed on the sample, the charge carrier concentration and/or the number and/or size and/or shape of defects and/or of particles in the sample or in at least one layer can be determined.

5. An arrangement in accordance with one of the preceding claims, **characterized in that** the detectors and the sample are movable along at least one axis relative to one another and in so doing preferably at a constant spacing from one another.

6. An arrangement in accordance with one of the preceding claims, **characterized in that** the radiation source has optical elements forming the electromagnetic radiation or a radiation source that emits an electromagnetic radiation diffusely over the surface, and that is in particular arranged within a hollow body and a diaphragm that avoids the incidence of scattered electromagnetic radiation is particularly preferably arranged in front of the detectors in the optical path of the electromagnetic radiation.

7. An arrangement in accordance with one of the preceding claims, **characterized in that** the sample is a multilayer design of a plurality of layers formed from different materials or substances.

**Revendications**

1. Dispositif destiné à déterminer avec une résolution spatiale la résistance électrique spécifique et/ou la conductivité électrique spécifique d'un échantillon et/ou d'au moins une couche formée sur une surface d'un échantillon en différents points, dans lequel une pluralité de détecteurs servant à l'analyse spectrale à résolution spatiale d'un rayonnement électromagnétique dans un intervalle de longueur d'onde sont disposés en rangs ou en rangs et en colonnes, et

les détecteurs sont reliés à une unité d'évaluation électronique et agencés de telle sorte qu'un rayonnement électromagnétique émis par une source de rayonnement à large bande frappe les détecteurs après avoir été réfléchi par la surface de l'échantillon et/ou d'une couche formée sur l'échantillon ou par la surface d'une couche contenue dans l'échantillon, dans lequel

l'irradiation se déroule de telle sorte qu'une intensité du rayonnement électromagnétique reste homogène sur une surface réfléchissant ou transmettant le rayonnement électromagnétique, et

l'unité d'évaluation électronique est configurée de telle sorte que

les signaux de mesure résolus spatialement et en longueur d'onde captés par les détecteurs dans un intervalle de longueur d'onde pour chaque position relevée,

sont comparés à une fonction résolue en longueur d'onde obtenue en calculant la propagation du rayonnement électromagnétique dans des systèmes multicouches en tenant compte des formules de Fresnel,

en utilisant un modèle optique pour décrire physiquement l'échantillon étudié, en tenant compte de l'évolution, en fonction de la longueur d'onde, de l'indice de réfraction optique linéaire n et du coefficient d'absorption k de tous les matériaux et/ou matières formant l'échantillon, dans lequel ledit indice de réfraction optique linéaire et ledit coefficient d'absorption de la matière ou du matériau d'intérêt peuvent être approximés à l'aide du modèle de Drude par une fonction physique de l'indice de réfraction complexe de la matière ou du matériau conducteur, et

peuvent être amenés à coïncider suffisamment avec l'évolution d'une courbe d'étalonnage en modifiant avantageusement les paramètres de Drude de la fonction physique,

afin de déterminer avec une résolution spatiale la résistance électrique spécifique et/ou la conductivité électrique spécifique en différents points, dans lequel

les détecteurs, l'unité d'évaluation électronique et la source de rayonnement forment un système d'imagerie hyperspectrale, dans lequel l'angle d'incidence du rayonnement électromagnétique est modifiable ou réglable de 60° à 80° par rapport à la normale de la surface de l'échantillon, dans lequel la détection et l'évaluation peuvent être réalisés selon plusieurs angles d'incidence différents.

2. Dispositif selon la revendication 1, **caractérisé en ce que** l'unité d'évaluation électronique est configurée de telle sorte que l'évolution de la courbe calculée peut être adaptée à l'évolution d'une courbe d'étalonnage de manière itérative en faisant varier des paramètres de l'équation de Drude.

3. Dispositif selon l'une des revendications précédentes, **caractérisé en ce que** la détection et l'évaluation peuvent être réalisés à l'aide d'un polariseur ayant un plan de polarisation connu et défini par rapport au plan d'incidence.

4. Dispositif selon l'une des revendications précédentes, **caractérisé en ce qu'**il est possible de déterminer la distribution latérale de l'épaisseur de la ou des couches,

la ou les constantes de réfraction optique ou leur évolution en fonction de la longueur d'onde,
la ou les constantes d'absorption ou leur évolution en fonction de la longueur d'onde,
la qualité de la surface ou de l'interface de l'échantillon ou d'au moins une couche formée sur l'échantillon,
la concentration en porteurs de charge et/ou le nombre et/ou la taille et/ou la forme des défauts et/ou particules présents dans l'échantillon ou dans au moins une couche.

5. Dispositif selon l'une des revendications précédentes, **caractérisé en ce que** les détecteurs et l'échantillon sont mobiles l'un par rapport à l'autre le long d'au moins un axe, de préférence à une distance constante l'un de l'autre.

6. Dispositif selon l'une des revendications précédentes, **caractérisé en ce que** la source de rayonnement présente des éléments optiques structurant le rayonnement électromagnétique ou une source de rayonnement émettant un rayonnement électromagnétique diffus sur la surface est disposée de préférence à l'intérieur d'un corps creux et, de manière particulièrement préférée, un diaphragme permettant d'éviter l'incidence d'un rayonnement électromagnétique diffusé est disposé devant les détecteurs sur la trajectoire du rayonnement électromagnétique.

7. Dispositif selon l'une des revendications précédentes, **caractérisé en ce que** l'échantillon est une structure constituée de plusieurs couches composées de matières ou matériaux différents.

# FIG 1

*variabel, eine Schicht muss mit einem Modell zur Beschreibung
leitfähiger Schichten (z.B. Drude-Modell) beschreibbar sein.

EP 3 265 788 B1

FIG 2

Startwerte
- $\rho = 0.0001\ \Omega\!\cdot\!cm$
- $\varepsilon_\infty = 4$
- $\tau = 8\ fs$
- $d = 195\ nm$
- $n, k$ Glas BK7

Optisches Modell

ITO*

Glas BK7

Berechnungen
- $n, k$ (ITO-Schicht)
- Fresnelkoeffizienten
- Transfermatrix
(Reflexion, Transmission gesamtes Schichtsystem)

Wiederholung für alle x-y Koordinaten

Regression der Drude-Parameter

Vergleich gemessener Spektren (x, y) mit berechneten Spektren

Daten Einzelspektren
(x, y Koordinaten)

x-y Verteilung des spezifischen Widerstandes $\rho$

$\rho$

Flächenwiderstand [Ohm]

x

y

$\lambda$

800 1000 1200 1400 1600 1800 2000 2200 2400

*ITO-indium tin oxide (Indiumzinnoxid); transparentes, leitfähiges Oxid

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4412238 A1
- JP 2011179971 A
- EP 1257806 B1
- US 5107119 A